# EUROPÄISCHE PATENTSCHRIFT

(11) **EP 3 052 348 B1**
(45) Veröffentlichungstag und Bekanntmachung des Hinweises auf die Patenterteilung: **17.04.2019**
(21) Anmeldenummer: 14784012.8
(22) Anmeldetag: 26.09.2014
(51) Int. Cl.: B60R 25/20, E05F 15/00, B60R 16/02, H02G 3/32, H01R 12/00, G01R 29/08

(54) **KAPAZITIVE SENSORANORDNUNG EINES KRAFTFAHRZEUGS**
CAPACITIVE SENSOR ARRANGEMENT OF A MOTOR VEHICLE
SYSTÈME DE CAPTEUR CAPACITIF D'UN VÉHICULE AUTOMOBILE

(30) Priorität: 01.10.2013 DE 102013110866
(43) Veröffentlichungstag der Anmeldung: 10.08.2016
(73) Patentinhaber: Brose Fahrzeugteile GmbH & Co. Kommanditgesellschaft, Bamberg, 96052 Bamberg (DE)
(72) Erfinder: DIETZEL, Renee, 96242 Sonnefeld (DE); WILD, Stefan, 96450 Coburg (DE)
(74) Vertreter: Gottschald, Jan
(86) Internationale Anmeldenummer: PCT/EP2014/070600
(87) Internationale Veröffentlichungsnummer: WO 2015/049170

(56) Entgegenhaltungen:
- EP-A1- 1 247 696
- EP-A2- 2 275 296
- EP-A2- 2 624 669
- WO-A2-2012/059100
- DE-A1-102004 060 618
- DE-A1-102010 027 872
- GB-A- 2 348 505

## Beschreibung

Die Erfindung betrifft eine kapazitive Sensoranordnung eines Kraftfahrzeugs gemäß dem Oberbegriff von Anspruch 1, ein Sensormodul mit einem Trägerbauteil und einer solchen Sensoranordnung gemäß dem Oberbegriff von Anspruch 12 und ein Verfahren zur Montage der Messelektrode einer solchen Sensoranordnung gemäß Anspruch 14.

Die in Rede stehende, kapazitive Sensoranordnung eines Kraftfahrzeugs lässt sich für ganz unterschiedliche Anwendungsbereiche einsetzen. Vorliegend steht die sensorgestützte Erfassung von Bedienereignissen im Vordergrund. Bei einem zu erfassenden Bedienereignis kann es sich beispielsweise um die Annäherung einer Person an das Kraftfahrzeug, um eine vorbestimmte Fußbewegung einer Person o. dgl. handeln. Die sensorgestützte Erfassung solcher Bedienereignisse löst entsprechende steuerungstechnische Reaktionen aus, beispielsweise das motorische Öffnen der Heckklappe des Kraftfahrzeugs.

Die bekannte Sensoranordnung (DE 10 2010 027 872 A1), von der die Erfindung ausgeht, weist eine längliche, flache Messelektrode auf, die in den Stoßfänger des Kraftfahrzeugs integriert ist. Zur Befestigung der Messelektrode ist im Stoßfänger ein Trägerbauteil vorgesehen, das eine Mehrzahl von Öffnungen aufweist. Jeder Öffnung ist ein separates Befestigungselement zugeordnet, das in einem ersten Arbeitsschritt mit der Messelektrode zu verbinden ist In einem zweiten Arbeitsschritt werden die Befestigungselemente nacheinander in die zugeordneten Öffnungen im Trägerbauteil eingeclipst. Die bekannte Sensoranordnung gewährleistet eine mechanisch robuste Befestigung der Messelektrode an dem Trägerbauteil. Optimierungspotential besteht im Bereich der Montagefreundlichkeit der Messelektrode.

Aus der DE 10 2004 060 618 A1 ist eine Sensoranordnung bekannt, bei der eine Messelektrode in einer Montagebewegung unter Haltezungen schiebbar ist.

Der Erfindung liegt das Problem zu Grunde, die bekannte Sensoranordnung derart auszugestalten und weiterzubilden, dass der Aufwand für die Montage der Messelektrode an einem Trägerbauteil reduziert wird.

Das obige Problem wird bei einer Sensoranordnung gemäß dem Oberbegriff von Anspruch 1 durch die Merkmale des kennzeichnenden Teils von Anspruch 1 gelöst.

Wesentlich ist die grundsätzliche Überlegung, dass das Befestigungselement, von dem vorzugsweise mehrere vorhanden und der Messelektrode zugeordnet sind, so ausgestaltet sein kann, dass die Befestigung und Arretierung der Messelektrode an dem Trägerbauteil in nur einem einzigen Arbeitsschritt erfolgt. Vorschlagsgemäß ist erkannt worden, dass dies durch die Ausstattung des Befestigungselements mit einer federelastisch aus einer Ruhestellung auslenkbaren Haltezunge und mit einem Arretierelement realisierbar ist.

Im Einzelnen ist die Anordnung vorschlagsgemäß so getroffen, dass die noch unmontierte Messelektrode in einer Montagebewegung zu ihrer Befestigung mit einer Flachseite unter die Haltezunge, die Haltezunge federelastisch auslenkend, schiebbar ist, wobei auch die Arretierung erfolgt. Bei entsprechender Ausrichtung der vorzugsweise mehreren Befestigungselemente ist es ohne Weiteres möglich, dass die Messelektrode in einem einzigen Arbeitsschritt mit einer einzigen Montagebewegung unter die Haltezungen der Befestigungselemente geschoben wird.

Durch die Reduzierung eines Arbeitsschritts bei der Befestigung der Messelektrode an dem Trägerbauteil lässt sich mit der vorschlagsgemäßen Lösung die Montagefreundlichkeit spürbar erhöhen. Gleichzeitig ist die konstruktive Umsetzung, nämlich die Ausstattung der Befestigungselemente mit Haltezunge, vergleichsweise kostengünstig.

Der Begriff "Messelektrode" ist vorliegend weit zu verstehen. Er umfasst alle Arten von Elektrodenanordnungen, die länglich und flach ausgestaltet sind. Darunter fallen auch Elektrodenanordnungen mit mehreren Einzelelektroden, die zu einer länglichen und flachen Anordnung zusammengefasst sind. Insbesondere fällt unter den Begriff "Messelektrode" eine Elektrode in Form eines sogenannten Flachleiters.

Bei der besonders bevorzugten Ausgestaltung gemäß Anspruch 2 erstreckt sich die Haltezunge des jeweiligen Befestigungselements quer zu der lokalen Längserstreckung der Messelektrode. Der Begriff "lokale Längserstreckung" betrifft die Längserstreckung, die die Messelektrode im Bereich des jeweiligen Befestigungselements aufweist. Diese Formulierung ist dem Umstand geschuldet, dass sich die Messelektrode entlang beliebiger Konturen längserstrecken kann.

Die weiter bevorzugten Ausgestaltungen gemäß den Ansprüchen 5 bis 9 betreffen die Ausstattung des Befestigungselements mit dem Arretierelement, mit dem die Arretierung der Messelektrode hinsichtlich einer Bewegung der Messelektrode parallel zu einer Flachseite der Messelektrode bewerkstelligt werden kann. Eine besonders hohe Montagefreundlichkeit ergibt sich gemäß Anspruch 6 dadurch, dass im Zuge der Montagebewegung die Messelektronik in arretierenden Eingriff schnappt, so dass die Arretierung selbsttätigt erfolgt.

Eine besonders genaue Positionierung der Messelektrode ergibt sich durch die weiter bevorzugte Ausführungsform gemäß Anspruch 10. Hier bewirkt die Federelastizität der Haltezunge in einer Variante ein Andrücken der Messelektrode an ein Wandelement, das Bestandteil des jeweiligen Befestigungselements oder des Trägerbauteils sein kann.

Vorschlagsgemäß ist es im Sinne einer über die Längserstreckung der Messelektrode gleichmäßigen Befestigung vorgesehen, dass mindestens zwei, insbesondere mehrere, Befestigungselemente vorgesehen sind. Alle Ausführungen zu einem einzelnen Befestigungselement gelten vorliegend für jedes dieser mindestens zwei Befestigungselemente.

Nach einer weiteren Lehre gemäß Anspruch 12, der eigenständige Bedeutung zukommt, wird ein Sensormodül mit einem Trägerbauteil und einer vorschlagsgemäßen Sensoranordnung beansprucht, wobei die Messelektrode der Sensoranordnung über das mindestens eine Befestigungselement an dem Trägerbauteil befestigt ist. Bei dem Trägerbauteil kann es sich um ein Karosseriebauteil, um eine Strukturkomponente, um einen Modulträger o. dgl. handeln. Das mindestens eine Befestigungselement kann je nach Anwendungsfall mittels verschiedener Verbindungstechniken an dem Trägerbauteil befestigt sein oder integraler Bestandteil des Trägerbauteils sein. Die Bereitstellung eines solchen Sensormoduls ist insbesondere vorteilhaft, als die gesamte Sensoranordnung in einem vormontierten Zustand insoweit aufgebaut ist, dass ein Funktionstest vor der Endmontage möglich ist.

Nach einer weiteren Lehre gemäß Anspruch 14, der ebenfalls eigenständige Bedeutung zukommt, wird ein Verfahren zur Montage der Messelektrode einer vorschlagsgemäßen, kapazitiven Sensoranordnung beansprucht. Wesentlich nach dieser weiteren Lehre ist, dass mindestens zwei Befestigungselemente vorgesehen sind und dass die Messelektrode in einer einzigen, insbesondere linearen, Montagebewegung zu ihrer Befestigung mit einer Flachseite unter die Haltezungen der Befestigungselemente, die Haltezungen federelastisch auslenkend, geschoben wird. Wie oben erläutert, lässt sich die Montage in einem einzigen Arbeitsschritt bewerkstelligen, was die Montagefreundlichkeit entsprechend erhöht.

Bei der besonders bevorzugten Ausgestaltung gemäß Anspruch 15 wird vorgeschlagen, dass die Messelektrode im Wesentlichen gleichzeitig unter die Haltezungen mindestens zweier Befestigungselemente, die Haltezungen federelastisch auslenkend zu ihrer Befestigung geschoben wird. Damit ist die Befestigung an den einzelnen Befestigungselementen im besten Falle auch gleichzeitig abgeschlossen, so dass die Gesamtdauer der Befestigung der Messelektrode entsprechend kurz ist.

Im Folgenden wird die Erfindung anhand einer lediglich ein Ausführungsbeispiel darstellenden Zeichnung näher erläutert. In der Zeichnung zeigt
- Fig. 1: ein Kraftfahrzeug mit einer vorschlagsgemäßen, kapazitiven Sensoranordnung in einer rückwärtigen Ansicht,
- Fig. 2: die Sensoranordnung gemäß Fig. 1 in einer perspektivischen Ansicht a) bei noch unmontierter Messelektrode und b) bei montierter Messelektrode,
- Fig. 3: ein Befestigungselement der Sensoranordnung gemäß Fig. 2 a) in einer perspektivischen Ansicht ohne Messelektrode und b) in einer perspektivischen Schnittansicht entlang der Schnittlinie B-B bei montierter Messelektrode,
- Fig. 4: ein Befestigungselement der Sensoranordnung gemäß Fig. 2 in einer zweiten Ausführungsform in den Ansichten gemäß Fig. 3 und
- Fig. 5: ein Befestigungselement der Sensoranordnung gemäß Fig. 2 in einem dritten Beispiel in den Ansichten gemäß Fig. 3.

Die vorschlagsgemäße, kapazitive Sensoranordnung 1 kann für vielfältige Anwendungsbereiche in einem Kraftfahrzeug Anwendung finden. Je nach Auslegung ermöglicht sie die sensorische Erfassung der Anwesenheit und/oder der Bewegung eines Gegenstands. Diese sensorische Erfassung geht auf eine Kapazitätsänderung der Messelektrode 2 gegenüber Masse oder gegenüber einer weiteren Messelektrode 2 zurück, die sich leicht elektronisch erfassen lässt. Hier und vorzugsweise dient die Sensoranordnung 1 der Erfassung eines Bedienereignisses, nämlich einer vorbestimmten Fußbewegung einer Person, wobei die sensorische Erfassung des Bedienereignisses ein motorisches Öffnen der Heckklappe 3 des Kraftfahrzeugs auslöst. Ein anderer beispielhafter Anwendungsbereich ist die Kollisionserkennung bei Kraftfahrzeugklappen.

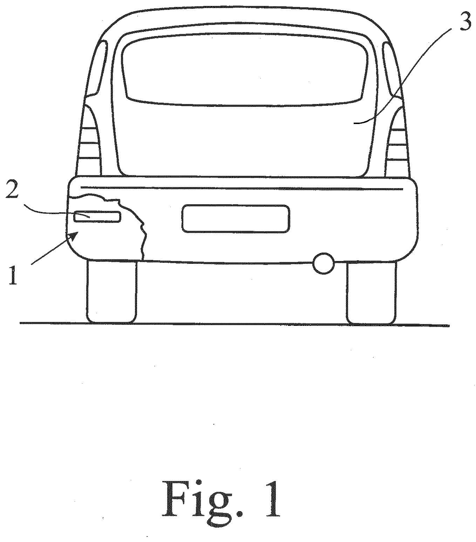

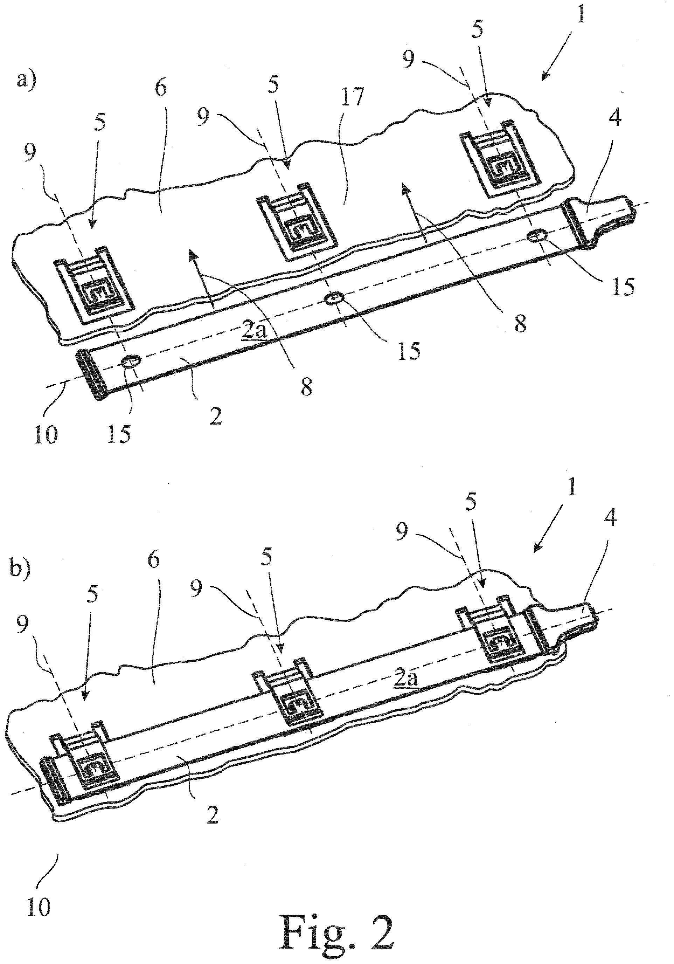

Eine Zusammenschau der Fig. 1 und 2 zeigt, dass die kapazitive Sensoranordnung 1 mit einer länglichen, flachen Messelektrode 2 ausgestattet ist. Entsprechend weist die Messelektrode 2 zwei gegenüberliegende, parallel zueinander ausgerichtete Flachseiten 2a und zwei gegenüberliegende Schmalseiten 2b auf. Vorzugsweise handelt es sich bei der Messelektrode 2 um einen Flachleiter, der in üblicher Weise mit einer Isolation ummantelt ist. Die Messelektrode 2 weist jedenfalls einen Anschluss 4 zur elektrischen Kontaktierung auf, der in Fig. 2 dargestellt ist.

Fig. 2 zeigt weiter, dass die Messelektrode 2 mindestens ein Befestigungselement 5 zur Befestigung der Messelektrode 2 an einem Trägerbauteil 6 aufweist. Vorzugsweise sind mindestens zwei Befestigungselemente 5 vorgesehen. Bei dem dargestellten Ausführungsbeispiel sind der Messelektrode 2 mehrere Befestigungselemente 5, nämlich insgesamt drei Befestigungselemente 5, an dem Trägerbauteil 6 vorgesehen. Damit lässt sich der die Messelektrode 2 umfassende Teil der Sensoranordnung 1 an dem Trägerbauteil 6 befestigen.

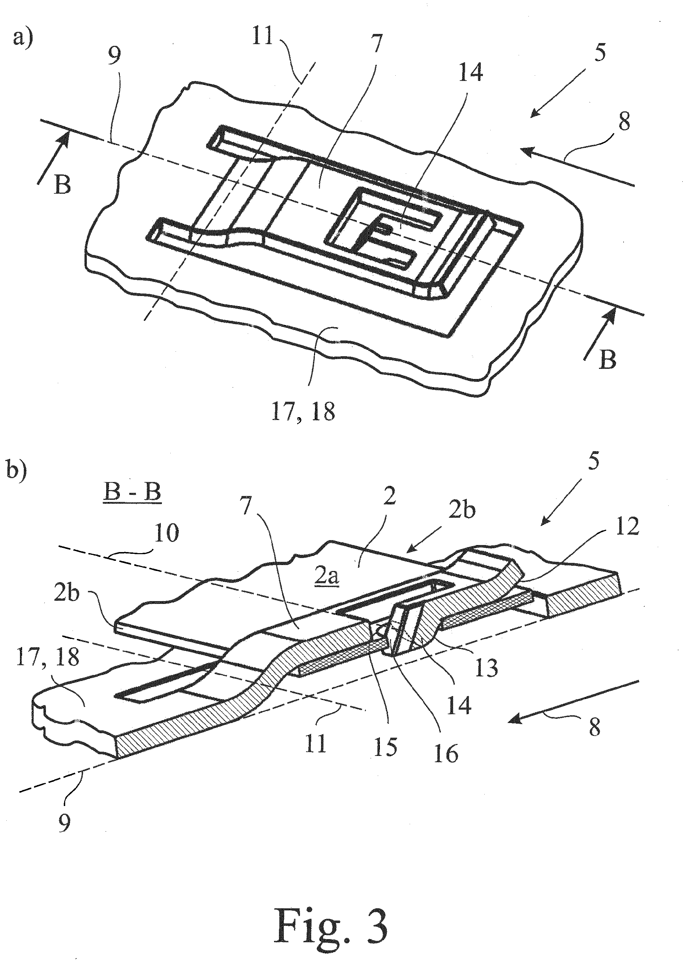

Die Fig. 3 bis 5 zeigen jeweils ein Exemplar der Befestigungselemente 5 in unterschiedlichen Ausführungsformen. Bei den dargestellten Ausführungsbeispielen sind die Befestigungselemente 5 jeweils integraler Bestandteil des Trägerbauteils 6. Grundsätzlich können die Befestigungselemente 5 aber auch als separate Bauteile vorliegen, die mit dem Trägerbauteil 6 verbindbar sind, wie noch erläutert wird.

Im Folgenden ist im Sinne einer übersichtlichen Darstellung fast durchweg von einem einzelnen Befestigungselement 5 die Rede. Alle diesbezüglichen Ausführungen gelten für alle übrigen Befestigungselemente 5 entsprechend.

Der konstruktiven Ausgestaltung des Befestigungselements 5 kommt vorliegend ganz besondere Bedeutung zu. Wesentlich dabei ist, dass das Befestigungselement 5 eine Haltezunge 7 aufweist, die federelastisch aus einer in Fig. 3a dargestellten Ruhestellung heraus auslenkbar ist. In Fig. 3a ist mit dieser Auslenkung eine Auslenkung der Haltezunge 7 nach oben gemeint. Die in Fig. 2a gezeigte, noch unmontierte Messelektrode 2 lässt sich so in einer Montagebewegung 8 zu ihrer Befestigung mit einer Flachseite 2a unter die Haltezunge 7, die Haltezunge 7 federelastisch auslenkend, schieben.

Die federelastische Auslenkung der Haltezunge 7 im Rahmen der Montagebewegung 8 kann je nach Anwendungsfall unterschiedlich genutzt werden. Eine Möglichkeit besteht darin, eine schnappende Arretierung der Messelektrode 2 zu realisieren. Eine andere Möglichkeit besteht darin, die federelastische Rückstellkraft der Haltezunge 7 für ein Andrücken der Messelektrode 2 zu nutzen. Dies wird weiter unten näher erläutert.

Die Haltezunge 7 des Befestigungselements 5 weist eine Längserstreckung 9 auf, wobei die Längserstreckung 9 der Haltezunge 7 im Wesentlichen quer zu der lokalen Längserstreckung 10 der Messelektrode 10 ausgerichtet ist. Es wurde bereits darauf hingewiesen, dass mit "lokale Längserstreckung" die Längserstreckung gemeint ist, die die Messelektrode 2 im Bereich des jeweiligen Befestigungselements 5 aufweist. Denkbar ist ja, dass sich die Messelektrode 2 entlang einer beliebigen Kontur längserstreckt, wie oben bereits erläutert wurde.

Hier und vorzugsweise ist die Auslenkbarkeit der Haltezunge 7 durch eine Biegbarkeit der Haltezunge 7 realisiert. Entsprechend ist es hier und vorzugsweise so, dass die Haltezunge 7 zumindest in einem Biegebereich, vorzugsweise vollständig, aus einem federelastisch biegbaren Material besteht. Dabei ist das Auslenken der Haltezunge 7 vorzugsweise ein Biegen der Haltezunge 7 um eine Biegeachse 11, die im Wesentlichen quer zu der Längserstreckung 9 der Haltezunge 7 ausgerichtet ist.

Die Anordnung ist nun so getroffen, dass die Montagebewegung 8 quer zu der lokalen Längserstreckung der Messelektrode 2 und parallel zu einer Flachseite 2a der Messelektrode 2 ausgerichtet ist. Bei der in Fig. 2 dargestellten Montagebewegung 8 handelt es sich um eine insgesamt lineare Montagebewegung 8, was die Montage der Messelektrode 2 vereinfacht. Denkbar ist sogar eine automatisierte, insbesondere robotergestützte Montage, ohne dass es aufwendiger Handhabungsvorrichtungen bedarf.

Interessant bei dem vorschlagsgemäßen Befestigungselement 5 ist die Tatsache, dass mit der Montagebewegung 8 das federelastische Auslenken der Haltezunge 7 einhergeht. Hierfür ist die Haltezunge 7 vorzugsweise mit mindestens einer Montageschräge 12, 13 ausgestattet, die mit der Messelektrode 2 während der Montagebewegung 8 in Eingriff kommt und dadurch eine Auslenkung der Haltezunge 7 bewirkt. Eine erste Montageschräge 12 ist an dem freien Ende der Haltezunge 7 angeordnet, die am besten der Darstellung gemäß Fig. 3b zu entnehmen ist. Während der Montagebewegung 8 kommt zunächst eine Schmalseite 2b der Messelektrode 2 in Eingriff mit der Montageschräge 12 am freien Ende der Haltezunge 7, was zu einem ersten Auslenken der Haltezunge 7 in Fig. 3b nach oben führt.

Die Realisierung der Montageschrägen 12, 13 lässt sich auf ganz unterschiedliche konstruktive Weise bewerkstelligen. Hier und vorzugsweise ist die an dem freien Ende der Haltezunge 7 angeordnete Montageschräge 12 schlicht nach Art einer Umbiegung der Haltezunge 7 geformt. Die weitere Montageschräge 13 wird weiter unten näher erläutert.

Bei allen dargestellten und insoweit bevorzugten Ausführungsbeispielen ist das Befestigungselement 5 mit einem Arretierelement 14 ausgestattet, das zur Arretierung der montierten Messelektrode 2 hinsichtlich einer Bewegung parallel zu einer Flachseite 2a der Messelektrode 2 formschlüssig mit der montierten Messelektrode 2 in Eingriff steht. Grundsätzlich ist es hier auch denkbar, dass ein kraftschlüssiger, insbesondere ein klemmender Eingriff zwischen dem Arretierelement 14 und der Messelektrode 2 zustande kommt. Grundsätzlich ist es weiter denkbar, dass das Arretierelement 14 der Messelektrode 2 oder einer weiteren Komponente zugeordnet ist, wie noch erläutert wird.

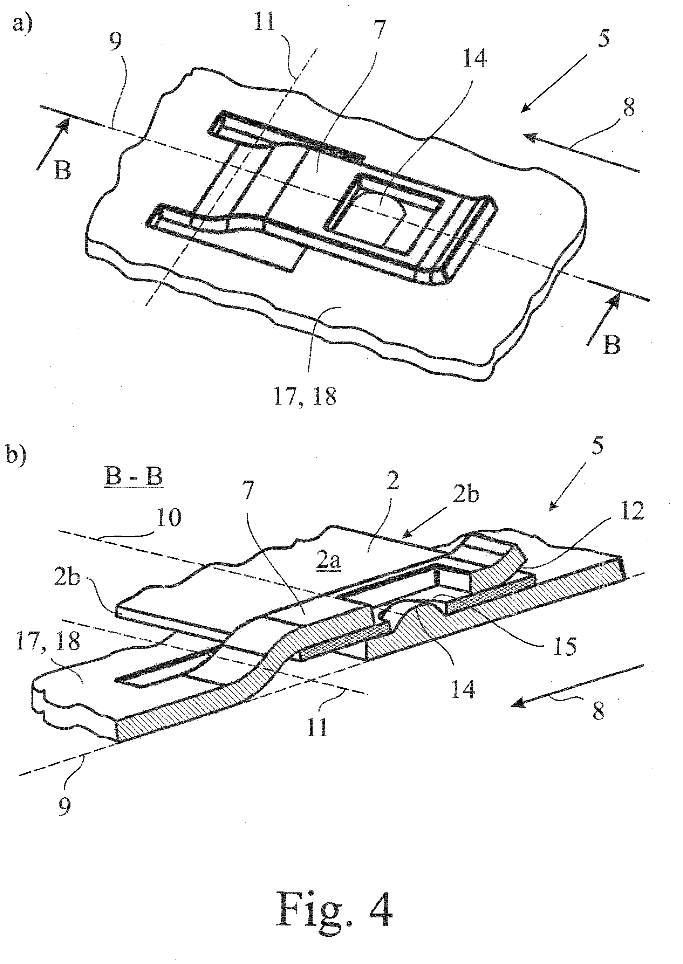

Die jeweiligen Schnittdarstellungen in den Fig. 3 und 4 zeigen, dass hier und vorzugsweise das Arretierelement 14 bei montierter Messelektrode 2 in eine Arretierausformung 15 in oder an der Messelektrode 2, insbesondere in eine Arretierausnehmung 15 in der Flachseite 2a der Messelektrode 2, eintaucht. Hier und vorzugsweise ist es weiter so, dass es sich bei der Arretierausnehmung 15 um ein durchgehendes Arretierloch in der Messelektrode 2 handelt.

Die in Fig. 2a gezeigten Arretierausnehmungen 15 in der Messelektrode 2 sind vorzugsweise nach Art von Langlöchern ausgestaltet. Die Längserstreckung der Langlöcher ist dabei vorzugsweise entlang der Längserstreckung 10 der Messelektrode 2 ausgerichtet. Damit lassen sich eventuelle Fertigungstoleranzen, etwa am Trägerbauteil 6 o. dgl., auf einfache Weise ausgleichen. Je nach Auslegung der Arretierausnehmungen 15 kann auch die Lage der Messelektrode 2 zumindest geringfügig entlang ihrer Längserstreckung 10 nachjustiert werden.

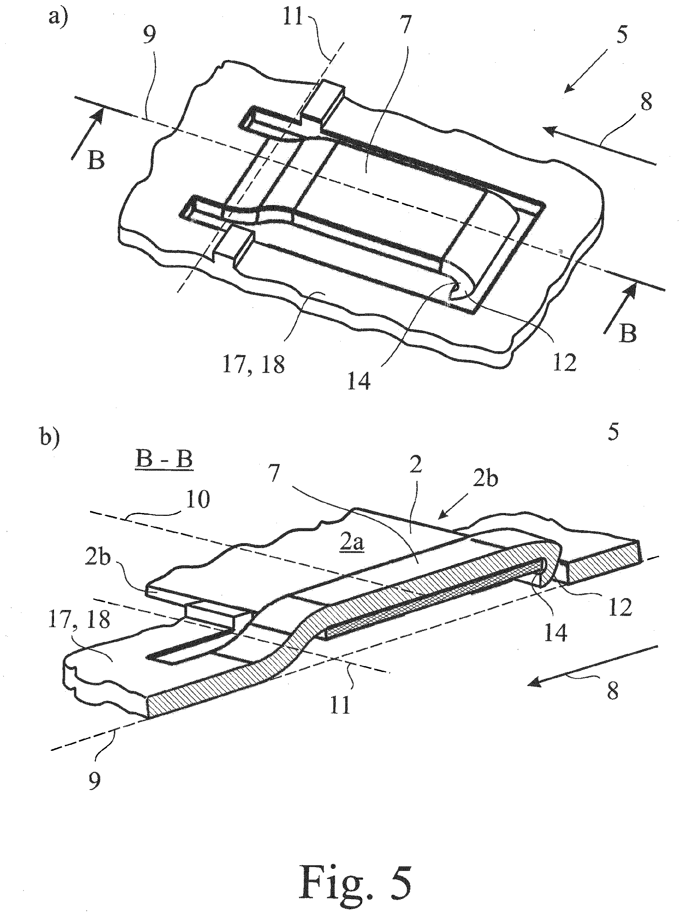

Bei der weiter bevorzugten Ausgestaltung gemäß Fig. 5 ist die Messelektrode 2 nicht notwendigerweise mit Arretierausnehmungen 15 ausgestattet. Das hakenförmige Arretierelement 14 kommt lediglich mit einer Schmalseite 2b der Messelektrode 2 in arretierenden Eingriff, wie noch erläutert wird.

Bei allen dargestellten Ausführungsformen ist es so, dass im Zuge der Montagebewegung 8 die Messelektrode 2 in arretierenden Eingriff mit dem Arretierelement 14 kommt. Dies ist hier und vorzugsweise jeweils getrieben durch die Rückstellkraft der Haltezunge 7, so dass die Messelektrode 2 im Zuge der Montagebewegung 8 in den arretierenden Eingriff mit dem Arretierelement 14 schnappt.

Bei montierter Messelektrode 2 wird eine Lösebewegung der Messelektrode 2 außer arretierenden Eingriff von dem Arretierelement 14 blockiert. Dies ergibt sich aus den jeweiligen Schnittdarstellungen der Fig. 3-5. Die Rückstellkraft der Haltezunge 7 sorgt dafür, dass die Blockierung einer Lösebewegung der Messelektrode 2 mechanisch hinreichend stabil ist, so dass sich eine sichere Befestigung der Messelektrode 2 ergibt. Allerdings lässt sich die Blockierung der Lösebewegung bei allen dargestellten und insoweit bevorzugten Ausführungsformen aufheben, indem die Haltezunge 7 federelastisch ausgelenkt wird. Durch eine Auslenkung der Haltezunge 7 in den Fig. 3-5 nach oben lässt sich die Lösebewegung der Messelektrode 2 leicht freigeben. Dies kann beispielsweise im Rahmen eines wartungsbedingten Austauschs der Messelektrode 2 notwendig sein.

Bei den in den Fig. 3 und 5 dargestellten Ausführungsformen ist das Arretierelement 14 Bestandteil des Befestigungselements 5 und jeweils an der Haltezunge 7 des Befestigungselements 5 angeordnet. Entsprechend folgt das Arretierelement 14 jeder Auslenkung der Haltezunge 7.

Bei dem in Fig. 4 dargestellten Ausführungsbeispiel ist es dagegen so, dass das Arretierelement 14 gegenüber der Haltezunge 7 feststehend angeordnet ist. Die Arretierung kommt hier dadurch zustande, dass die Messelektrode 2 durch die Haltezunge 7 in arretierendem Eingriff mit dem feststehenden Arretierelement gehalten wird. Bei den in den Fig. 3-5 dargestellten Ausführungsformen ist es dagegen so, dass das Arretierelement 14 selbst mittels der Haltezunge 7 in entsprechendem arretierendem Eingriff mit der Messelektrode 2 gehalten wird.

Es kann aber auch vorteilhaft sein, dass das Arretierelement an der Messelektrode 2 angeordnet, insbesondere Bestandteil der Messelektrode 2, ist. In diesem Fall ist das Befestigungselement 5, vorzugsweise die Haltezunge 7, mit einer Arretierausnehmung o. dgl. ausgestattet, so dass Arretierelement und Arretierausnehmung zur Arretierung der montierten Messelektrode 2 hinsichtlich einer Bewegung parallel zu einer Flachseite 2a der Messelektrode 2 formschlüssig miteinander in Eingriff stehen.

Ein interessanter Aspekt im Hinblick auf die Ausgestaltung des Arretierelements 14 lässt sich der Darstellung gemäß Fig. 3 entnehmen. Hier ist es vorgesehen, dass das Arretierelement 14 gegenüber der Haltezunge 7 federelastisch auslenkbar, hier biegbar, ist, wobei die Biegeachse des Arretierelements 14 gegenüber der Haltezunge 7 im Wesentlichen parallel zu der Biegeachse 11 der Haltezunge 7 selbst ausgerichtet ist. Diese zusätzliche Federelastizität ist insbesondere vorteilhaft, wenn der arretierende Eingriff, wie oben angesprochen, schnappend erfolgen soll.

Es wurde schon darauf hingewiesen, dass Arretierausnehmungen 15 in der Messelektrode 2 bei der in Fig. 5 dargestellten Ausführungsform des Befestigungselements 5 nicht erforderlich sind. Die Arretierbarkeit der Messelektrode 2 mittels des Arretierelements 14 ist bei dieser Ausführungsform ausschließlich in einer Richtung quer zu der lokalen Längserstreckung 10 der Messelektrode 2 vorgesehen. Vorteilhaft dabei ist die Tatsache, dass eine oben angesprochene Nachjustierung der Lage der Messelektrode 2 entlang ihrer Längserstreckung 10 ohne weiteres möglich ist. Eine besonders einfache konstruktive Realisierung hierfür ergibt sich dadurch, dass das Arretierelement 14 an dem freien Ende der Haltezunge 7 angeordnet ist und im Längsschnitt der Haltezunge 7 gesehen hakenartig ausgeformt ist. Ganz allgemein stellt das Arretierelement 14 hier einen Teil einer Längsführung für die Messelektrode 2 in Richtung der lokalen Längserstreckung 10 der Messelektrode 2 bereit.

Bei den in den Fig. 3 und 5 dargestellten und insoweit bevorzugten Ausführungsformen ist es so, dass das Arretierelement 14 eine oben angesprochene Montageschräge 13 der Haltezunge 7 bereitstellt, mit der eine Schmalseite der Messelektrode 2 während der Montagebewegung 8, die Haltezunge 7 auslenkend, in Eingriff kommt. Alternativ oder zusätzlich kann das Arretierelement 14 eine hakenartige Ausformung 16 aufweisen derart, dass eine Bewegung der montierten Messelektrode 2 entgegen der Montagrichtung eine Kraft auf die Haltezunge 7 in Richtung der Ruhestellung und damit eine Klemmung erzeugt. Eine solche hakenartige Ausformung 16 ist bei der in Fig. 3b gezeigten Haltezunge 7 an einer Seite des Arretierelements 14 gezeigt, die zu der dortigen Montageschräge 13 gegenüberliegend angeordnet ist.

Alternativ zu der obigen, hakenartigen Ausformung 16 kann am Arretierelement 14 eine Anlaufschräge vorgesehen sein, die in Fig. 3b in gestrichelter Linie dargestellt ist. Mit einer solchen Anlaufschräge ist es möglich, dass eine Bewegung der Messelektrode 2 entgegen der Montagebewegung 8 zu einem Ausheben der Haltezunge 7 und damit der Freigabe der Lösebewegung der Messelektrode 2 führt. Bei geeigneter Auslegung ist eine solche Freigabe der Lösebewegung der Messelektrode 2 nur möglich, wenn eine vorbestimmte Mindestkraft auf die Messelektrode 2 aufgebracht wird.

Es wurde schon darauf hingewiesen, dass die Rückstellkraft der Haltezunge 7 für das Einschnappen des Arretierelements 14 in arretierenden Eingriff mit der Messelektrode 2 und für die Blockierung einer Lösebewegung der Messelektrode 2 genutzt werden kann. Vorzugsweise kommt der Rückstellkraft zusätzlich das Andrücken der Messelektrode 2 zu. Im Einzelnen ist es vorzugsweise so, dass bei montierter Messelektrode 2 die Haltezunge 7 des Befestigungselements 5 zumindest geringfügig federelastisch ausgelenkt ist, wobei die federelastische Rückstellkraft auf die Messelektrode 2 wirkt. Hier und vorzugsweise wirkt die Rückstellkraft im Wesentlichen quer zu einer Flachseite 2a der Messelektrode 2. Um eine Befestigung der Messelektrode 2 möglichst positionsgenau zu ermöglichen, ist es weiter vorzugsweise so, dass bei montierter Messelektrode 2 die Haltezunge 7 über ihre Rückstellkraft die Messelektrode 2 an ein Wandelement 17, hier und vorzugsweise an ein Wandelement 17 des Befestigungselements 5 oder des Trägerbauteils 6, drückt.

Der strukturellen Ausgestaltung des Befestigungselements 5 kommt vorliegend ganz besondere Bedeutung zu. Das Befestigungselement 5 weist vorzugsweise einen Halterahmen 18 auf, innerhalb dessen die Haltezunge 7 angeordnet ist. Hier und vorzugsweise ist der Halterahmen 18 integraler Bestandteil des Trägerbauteils 6. Es lässt sich den Darstellungen gemäß den Fig. 3-5 entnehmen, dass der Halterahmen 18 einstückig mit der Haltezunge 7 ausgestaltet ist. Der Halterahmen 18 übernimmt hier eine Abstützung gegenüber der Rückstellkraft der Haltezunge 7.

Die Ausgestaltung des Befestigungselements 5 mit Haltezunge 7 und Halterahmen 18 ist für die Ausgestaltung des Befestigungselements 5 als separates Bauteil, das mit dem Trägerbauteil 6 zu verbinden ist, besonders vorteilhaft. Hierdurch lässt sich nämlich leicht erreichen, dass der auf die federelastische Rückstellkraft zurückgehende Kraftfluss geschlossen über das Befestigungselement 5 und die Messelektrode 2, im Einzelnen über die Haltezunge 7, die Messelektrode 2 und den Halterahmen 18, verläuft. Dies ist vorteilhaft, da die Verbindung des Befestigungselements 5 mit dem Trägerbauteil 6 durch die federelastische Rückstellkraft der Haltezunge 7 nicht belastet wird.

Wie oben angesprochen, ist der Halterahmen 18 einstückig mit der Haltezunge 7 ausgestaltet, was fertigungstechnisch besonders einfach dadurch realisierbar ist, dass der Halterahmen 14 zusammen mit der Haltezunge 7 im Kunststoff-Spritzgießverfahren hergestellt ist.

In besonders bevorzugter Ausgestaltung ist das Befestigungselement 5 so ausgestaltet, dass es sich mittels eines schieberlosen Auf-Zu-Werkzeugs im Kunststoff-Spritzgießverfahren herstellen lässt.

Die Verbindung des Befestigungselements 5 mit dem Trägerbauteil 6 ist auf ganz unterschiedliche Weise möglich. In besonders bevorzugter Ausgestaltung ist das Befestigungselement 5 an das Trägerbauteil 6 anklebbar, anschweißbar oder anklipsbar. Denkbar ist auch wie oben angesprochen, dass das Befestigungselement 5 ein integraler Bestandteil des Trägerbauteils 6 ist. Insbesondere kann das Befestigungselement 5 gemeinsam mit dem Trägerbauteil 6 im Kunststoff-Spritzgießverfahren hergestellt sein.

Grundsätzlich ist es denkbar, dass der Messelektrode 2 lediglich ein einziges Befestigungselement 5 zugeordnet ist. Hier und vorzugsweise ist es allerdings so, dass mindestens zwei, insbesondere mehrere Befestigungselemente 5, vorgesehen sind, die entlang der Messelektrode 2 angeordnet sind. Entsprechend ist bei den bevorzugten Ausführungsformen gemäß den Fig. 3 und 4 die Messelektrode 2 entlang ihrer Längserstreckung 10 mit mehreren Arretierausnehmungen 15 ausgestattet, die jeweils einem Arretierelement 14 eines Befestigungselements 5 zugeordnet sind.

Nach einer weiteren Lehre, der ebenfalls eigenständige Bedeutung zukommt, wird ein Sensormodul mit einem Trägerbauteil 6 und einer obigen, kapazitiven Sensoranordnung 1 beansprucht. Wesentlich dabei ist die Tatsache, dass die Messelektrode 2 der Sensoranordnung 1 über das mindestens eine Befestigungselement 5 an dem Trägerbauteil 6 befestigt ist. Auf alle Ausführungen zu der vorschlagsgemäßen kapazitiven Sensoranordnung 1 darf verwiesen werden.

Wie weiter oben erläutert, kann es sich bei dem Trägerbauteil 6 um ein Karosseriebauteil, insbesondere um einen Stoßfänger oder eine Heckschürze, um eine Heckklappe, o.dgl. handeln. Denkbar ist auch, dass das Trägerbauteil 6 eine Strukturkomponente wie ein Türrahmen o. dgl. ist. Es kann auch vorteilhaft sein, dass das Trägerbauteil 6 ein Modulträger ist, der, ggf. mit weiteren Funktionseinheiten, in einem dem Zusammenbau des Sensormoduls nachgelagerten Montageschritt endmontiert wird.

Vorzugsweise ist das Befestigungselement 5 einstückig mit dem Trägerbauteil 6 verbunden, wie in Fig. 2 dargestellt. Hier und vorzugsweise ist das Befestigungselement 5 einstückig mit einem Wandelement 17 des Trägerbauteils 6 verbunden ist, wobei weiter vorzugsweise sich das Befestigungselement 5 im Wesentlichen parallel zu der Wandebene des Wandelements 17 erstreckt.

Nach einer weiteren Lehre, der ebenfalls eigenständige Bedeutung zukommt, wird ein Verfahren zur Montage der Messelektrode 2 einer kapazitiven, vorschlagsgemäßen Sensoranordnung 1 beansprucht. Wesentlich für das Verfahren ist, dass mindestens zwei Befestigungselemente 5 vorgesehen sind und dass die Messelektrode 2 in einer einzigen, hier und vorzugsweise linearen, Montagebewegung 8 zu ihrer Befestigung mit einer Flachseite 2a unter die Haltezungen 7 der Befestigungselemente 5, die Haltezungen 7 wie oben erläutert federelastisch auslenkend, geschoben wird. Es wurde schon darauf hingewiesen, dass eine solche Montage mit einem einzigen Arbeitsschritt bewerkstelligt werden kann, was die Montagefreundlichkeit erhöht. Die Montage kann manuell, mittels einer Montagevorrichtung oder automatisiert, insbesondere mittels eines Roboters, vorgenommen werden.

In besonders bevorzugter Ausgestaltung ist es so, dass die Messelektrode 2 im Wesentlichen gleichzeitig unter die Haltezungen 7 mindestens zweier Befestigungselemente 5, die Haltezungen 7 federelastisch auslenkend, zu ihrer Befestigung geschoben wird. Dies vereinfacht und beschleunigt den Montagevorgang, wie ebenfalls weiter oben erläutert wurde.

## Patentansprüche

1. Kapazitive Sensoranordnung eines Kraftfahrzeugs mit einer länglichen, flachen Messelektrode (2) und mindestens einem Befestigungselement (5) zur Befestigung der Messelektrode (2) an einem Trägerbauteil (6),
**dadurch gekennzeichnet,**
**dass** das Befestigungselement (5) eine federelastisch aus einer Ruhestellung auslenkbare Haltezunge (7) aufweist,
**dass** die noch unmontierte Messelektrode (2) zu ihrer Befestigung in einer Montagebewegung (8) mit einer Flachseite (2a) unter die Haltezunge (7), die Haltezunge (7) federelastisch auslenkend, schiebbar ist,
**dass** die Montagebewegung (8) quer zu der lokalen Längserstreckung (10) der Messelektrode (2) und parallel zu einer Flachseite (2a) der Messelektrode (2) ausgerichtet ist,
**dass** ein Arretierelement (14) vorgesehen ist, das zur Arretierung der montierten Messelektrode (2) hinsichtlich einer Bewegung parallel zu einer Flachseite (2a) der Messelektrode (2) formschlüssig oder kraftschlüssig mit der montierten Messelektrode (2) in Eingriff steht, und
**dass** mindestens zwei Befestigungselemente (5) vorgesehen sind, die entlang der Messelektrode (2) angeordnet sind, und die Messelektrode (2) entlang ihrer Längserstreckung (10) mehrere Arretierausnehmungen (15) aufweist, die jeweils einem Arretierelement (14) eines Befestigungselements (5) zugeordnet sind.

2. Sensoranordnung nach Anspruch 1, **dadurch gekennzeichnet, dass** die Haltezunge (7) des Befestigungselements (5) eine Längserstreckung (9) aufweist und dass die Längserstreckung (9) der Haltezunge (7) im Wesentlichen quer zu der lokalen Längserstreckung (10) der Messelektrode (2) ausgerichtet ist, vorzugsweise, dass das Auslenken der Haltezunge (7) ein Biegen der Haltezunge (7) ist um eine Biegeachse (11), die im Wesentlichen quer zu der Längserstreckung (9) der Haltezunge (7) ausgerichtet ist.

3. Sensoranordnung nach Anspruch 1 oder 2, **dadurch gekennzeichnet, dass** die Haltezunge (7) des Befestigungselements (5) mindestens eine Montageschräge (12, 13) aufweist, die mit der Messelektrode (2) während der Montagebewegung (8) in Eingriff kommt und dadurch eine Auslenkung der Haltezunge (7) bewirkt.

4. Sensoranordnung nach Anspruch 3, **dadurch gekennzeichnet, dass** die Montageschräge (12, 13) an dem freien Ende der Haltezunge (7) angeordnet ist.

5. Sensoranordnung nach einem der vorhergehenden Ansprüche, **dadurch gekennzeichnet, dass** das Arretierelement (14) bei montierter Messelektrode (2) in eine Arretierausformung (15) in oder an der Messelektrode (2), vorzugsweise in eine Arretierausnehmung (15) in der Flachseite (2a) der Messelektrode (2), eintaucht, vorzugsweise, dass im Zuge der Montagebewegung die Messelektrode (2) in arretierenden Eingriff mit dem Arretierelement (14) kommt, insbesondere, getrieben durch die Rückstellkraft der Haltezunge (7), in arretierenden Eingriff mit dem Arretierelement (14) schnappt.

6. Sensoranordnung nach Anspruch 5, **dadurch gekennzeichnet, dass** die Haltezunge (7) bei montierter Messelektrode (2) eine Lösebewegung der Messelektrode (2) außer arretierenden Eingriff von dem Arretierelement (14) blockiert, vorzugsweise, dass durch eine federelastische Auslenkung der Haltezunge (7) die Lösebewegung der Messelektrode (2) freigebbar ist.

7. Sensoranordnung nach einem der Ansprüche 5 oder 6, **dadurch gekennzeichnet, dass** das Arretierelement (14) an der Haltezunge (7) des Befestigungselements (5) angeordnet ist, oder, dass das Arretierelement (14) gegenüber der Haltezunge (7) feststehend angeordnet ist, oder, dass das Arretierelement (14) an der Messelektrode (2) angeordnet ist.

8. Sensoranordnung nach einem der Ansprüche 5 bis 7, **dadurch gekennzeichnet, dass** die Messelektrode (2) mittels des Arretierelements (14) ausschließlich in einer Richtung quer zu der lokalen Längserstreckung (10) der Messelektrode (2) arretierbar ist, vorzugsweise, dass das Arretierelement (14) an dem freien Ende der Haltezunge (7) angeordnet ist, weiter vorzugsweise, dass das Arretierelement (14) als Teil einer Längsführung für die Messelektrode (2) in Richtung der lokalen Längserstreckung (10) der Messelektrode (2) ausgestaltet ist.

9. Sensoranordnung nach einem der Ansprüche 5 bis 8, **dadurch gekennzeichnet, dass** das Arretierelement (14) eine Montageschräge (13) der Haltezunge (7) bereitstellt, und/oder, dass das Arretierelement (14) eine hakenartige Ausformung (16) aufweist derart, dass eine Bewegung der montierten Messelektrode (2) entgegen der Montagebewegung (8) eine Kraft auf die Haltezunge (7) in Richtung der Ruhestellung erzeugt.

10. Sensoranordnung nach einem der vorhergehenden Ansprüche, **dadurch gekennzeichnet, dass** bei montierter Messelektrode (2) die Haltezunge (7) des Befestigungselements (5) zumindest geringfügig federelastisch ausgelenkt ist und die federelastische Rückstellkraft auf die Messelektrode (2), insbesondere im Wesentlichen quer zu einer Flachseite (2a) der Messelektrode (2), wirkt, vorzugsweise, dass bei montierter Messelektrode (2) die Haltezunge (7) über ihre Rückstellkraft die Messelektrode (2) an ein Wandelement (17), vorzugsweise an ein Wandelement (17) des Befestigungselements (5) oder des Trägerbauteils (6), drückt.

11. Sensoranordnung nach einem der vorhergehenden Ansprüche, **dadurch gekennzeichnet, dass** das Befestigungselement (5) einen Halterahmen (18) aufweist, innerhalb dessen die Haltezunge (7) angeordnet ist, vorzugsweise, dass der Halterahmen (18) einstückig mit der Haltezunge (7) ausgestaltet ist, weiter vorzugsweise, dass der Halterahmen (8) zusammen mit der Haltezunge (7) im Kunststoff-Spritzgießverfahren hergestellt ist.

12. Sensormodul mit einem Trägerbauteil (6) und einer kapazitiven Sensoranordnung (1) nach einem der vorhergehenden Ansprüche, wobei die Messelektrode (2) der Sensoranordnung (1) über das mindestens eine Befestigungselement (5) an dem Trägerbauteil (6) befestigt ist.

13. Sensormodul nach Anspruch 12, **dadurch gekennzeichnet, dass** das Befestigungselement (5) einstückig mit dem Trägerbauteil (6) verbunden ist, vorzugsweise, dass das Befestigungselement (5) einstückig mit einem Wandelement (17) des Trägerbauteils (6) verbunden ist, vorzugsweise, dass sich das Befestigungselement (5) im Wesentlichen parallel zu der Wandebene des Wandelements (17) erstreckt.

14. Verfahren zur Montage der Messelektrode einer kapazitiven Sensoranordnung (1) nach einem der Ansprüche 1 bis 13, wobei mindestens zwei Befestigungselemente (5) vorgesehen sind und wobei die Messelektrode (2) in einer einzigen, insbesondere linearen, Montagebewegung (8) zu ihrer Befestigung mit einer Flachseite (2a) unter die Haltezungen (7) der Befestigungselemente (5), die Haltezungen (7) federelastisch auslenkend, geschoben wird.

15. Verfahren nach Anspruch 14, **dadurch gekennzeichnet, dass** die Messelektrode (2) im Wesentlichen gleichzeitig unter die Haltezungen (7) mindestens zweier Befestigungselemente (5), die Haltezungen (7) federelastisch auslenkend, zu ihrer Befestigung geschoben wird.

## Claims

1. Capacitive sensor arrangement for a motor vehicle, comprising an elongate, flat measuring electrode (2) and at least one fastening element (5) for fastening the measuring electrode (2) on a support component (6),
**characterized in that**
the fastening element (5) has a retaining tongue (7), which can be elastically deflected out of a rest position,
the uninstalled measuring electrode (2) can be slid, for the fastening thereof, underneath the retaining tongue (7) via a flat side (2a) in an installation motion (8), which elastically deflects the retaining tongue (7),
the installation motion (8) is oriented transversely to the local longitudinal extension (10) of the measuring electrode (2) and parallel to a flat side (2a) of the measuring electrode (2),
a locking element (14) is provided, which is engaged with the installed measuring electrode (2) in an interlocking or force-locked manner for locking the installed measuring electrode (2) with respect to a motion parallel to a flat side (2a) of the measuring electrode (2), and at least two fastening elements (5) are provided, which are disposed along the measuring electrode (2), and the measuring electrode (2), along its longitudinal extension (10), has multiple locking recesses (15), each of which is assigned to a locking element (14) of a fastening element (5).

2. Sensor arrangement according to Claim 1, **characterized in that** the retaining tongue (7) of the fastening element (5) has a longitudinal extension (9), and the longitudinal extension (9) of the retaining tongue (7) is oriented essentially transversely to the local longitudinal extension (10) of the measuring electrode (2), preferably the deflection of the retaining tongue (7) is a bending of the retaining tongue (7) about a bend axis (11), which is oriented essentially transversely to the longitudinal extension (9) of the retaining tongue (7).

3. Sensor arrangement according to Claim 1 or 2, **characterized in that** the retaining tongue (7) of the fastening element (5) has at least one installation bevel (12, 13), which engages with the measuring electrode (2) during the installation motion (8) and thereby induces a deflection of the retaining tongue (7) .

4. Sensor arrangement according to Claim 3, **characterized in that** the installation bevel (12, 13) is disposed on the free end of the retaining tongue (7).

5. Sensor arrangement according to one of the preceding claims, **characterized in that**, with the measuring electrode (2) installed, the locking element (14) plunges into a locking recess (15) in or on the measuring electrode (2), preferably into a locking recess (15) in the flat side (2a) of the measuring electrode (2), preferably **in that** the measuring electrode (2) enters into locking engagement with the locking element (14) in the course of the installation motion, in particular, driven by the restoring force of the retaining tongue (7), snaps into locking engagement with the locking element (14).

6. Sensor arrangement according to Claim 5, **characterized in that**, with the measuring electrode (2) installed, the retaining tongue (7) blocks a loosening motion of the measuring electrode (2) out of the locking engagement with the locking element (14), preferably the loosening motion of the measuring electrode (2) can be released via an elastic deflection of the retaining tongue (7).

7. Sensor arrangement according to one of Claims 5 and 6, **characterized in that** the locking element (14) is disposed on the retaining tongue (7) of the fastening element (5), or the locking element (14) is fixedly disposed with respect to the retaining tongue (7), or the locking element (14) is disposed on the measuring electrode (2).

8. Sensor arrangement according to one of Claims 5 to 7, **characterized in that** the measuring electrode (2) can be locked, by means of the locking element (14), exclusively in a direction transversely to the local longitudinal extension (10) of the measuring electrode (2), preferably the locking element (14) is disposed on the free end of the retaining tongue (7), further preferably, the locking element (14) is designed as part of a longitudinal guide for the measuring electrode (2) in the direction of the local longitudinal extension (10) of the measuring electrode (2) .

9. Sensor arrangement according to one of Claims 5 to 8, **characterized in that** the locking element (14) provides an installation bevel (13) of the retaining tongue (7), and/or the locking element (14) has a hook-like form (16) such that a motion of the installed measuring electrode (2) opposite the installation motion (8) generates a force onto the retaining tongue (7) in the direction of the rest position.

10. Sensor arrangement according to one of the preceding claims, **characterized in that**, when the measuring electrode (2) is installed, the retaining tongue (7) of the fastening element (5) is at least slightly elastically deflected and the elastic restoring force acts on the measuring electrode (2), in particular essentially transversely to a flat side (2a) of the measuring electrode (2), preferably, when the measuring electrode (2) is installed, the retaining tongue (7) presses, via its restoring force, the measuring electrode (2) against a wall element (17), preferably against a wall element (17) of the fastening element (5) or of the support component (6).

11. Sensor arrangement according to one of the preceding claims, **characterized in that** the fastening element (5) has a retaining frame (18), within which the retaining tongue (7) is disposed, preferably the retaining frame (18) is integral with the retaining tongue (7), further preferably the retaining frame (8) is manufactured together with the retaining tongue (7) via plastic injection-molding.

12. Sensor module comprising a support component (6) and a capacitive sensor arrangement (1) according to one of the preceding claims, wherein the measuring electrode (2) of the sensor arrangement (1) is fastened on the support component (6) via the at least one fastening element (5).

13. Sensor module according to Claim 12, **characterized in that** the fastening element (5) is connected to the support component (6) as a single piece, preferably the fastening element (5) is connected to a wall element (17) of the support component (6) as a single piece, preferably the fastening element (5) extends essentially parallel to the wall plane of the wall element (17).

14. Method for installing the measuring electrode of a capacitive sensor arrangement (1) according to one of Claims 1 to 13, wherein at least two fastening elements (5) are provided, and wherein the measuring electrode (2) is slid, for the fastening thereof, underneath the retaining tongues (7) of the fastening elements (5) via a flat side (2a) in a single, in particular linear installation motion (8), which elastically deflects the retaining tongues (7).

15. Method according to Claim 14, **characterized in that** the measuring electrode (2) is slid, for the fastening thereof, underneath the retaining tongues (7) of at least two fastening elements (5) essentially simultaneously, which elastically deflects the retaining tongues (7).

## Revendications

1. Système de capteur capacitif d'un véhicule automobile, comprenant une électrode de mesure (2) plate et allongée et au moins un élément de fixation (5) permettant de fixer l'électrode de mesure (2) à un composant de support (6),
**caractérisé en ce que** l'élément de fixation (5) comporte une languette de retenue (7) pouvant être déviée élastiquement à partir d'une position de repos, **en ce que** l'électrode de mesure (2) non encore montée, pour sa fixation, peut être poussée sous la languette de retenue (7) par une face plate (2a) dans un mouvement de montage (8) qui dévie élastiquement la languette de retenue (7),
**en ce que** le mouvement de montage (8) est orienté transversalement à l'extension longitudinale locale (10) de l'électrode de mesure (2) et parallèlement à une face plate (2a) de l'électrode de mesure (2),
**en ce qu'**il est prévu un élément de blocage (14) qui s'engage par complémentarité de forme ou par complémentarité de force sur l'électrode de mesure (2) montée pour bloquer l'électrode de mesure (2) montée par rapport à un mouvement parallèle à une face plate (2a) de l'électrode de mesure (2), et
**en ce qu'**il est prévu au moins deux éléments de fixation (5) disposés le long de l'électrode de mesure (2) et **en ce que** l'électrode de mesure (2) présente plusieurs évidements de blocage (15) sur son extension longitudinale (10), qui sont respectivement associés à un élément de blocage (14) d'un élément de fixation (5) .

2. Système de capteur selon la revendication 1, **caractérisé en ce que** la languette de retenue (7) de l'élément de fixation (5) présente une extension longitudinale (9) et **en ce que** l'extension longitudinale (9) de la languette de retenue (7) est orientée sensiblement transversalement à l'extension longitudinale locale (10) de l'électrode de mesure (2), de préférence, **en ce que** la déviation de la languette de retenue (7) est une flexion de la languette de retenue (7) autour d'un axe de flexion (11) orienté sensiblement transversalement à l'extension longitudinale (9) de la languette de retenue (7).

3. Système de capteur selon la revendication 1 ou 2, **caractérisé en ce que** la languette de retenue (7) de l'élément de fixation (5) présente au moins un chanfrein de montage (12, 13) qui s'engage sur l'électrode de mesure (2) pendant le mouvement de montage (8) et provoque ainsi une déviation de la languette de retenue (7).

4. Système de capteur selon la revendication 3, **caractérisé en ce que** le chanfrein de montage (12, 13) est disposé à l'extrémité libre de la languette de retenue (7).

5. Système de capteur selon l'une des revendications précédentes, **caractérisé en ce que**, lorsque l'électrode de mesure (2) est montée, l'élément de blocage (14) plonge dans une formation de blocage (15) ménagée dans ou sur l'électrode de mesure (2), de préférence dans un évidement de blocage (15) ménagé dans la face plate (2a) de l'électrode de mesure (2), de préférence, **en ce qu'**au cours du mouvement de montage, l'électrode de mesure (2) s'engage de manière bloquante sur l'élément de blocage (14), et s'engage en particulier de manière bloquante sur l'élément de blocage (14) en étant entraînée par la force de rappel de la languette de retenue (7).

6. Système de capteur selon la revendication 5, **caractérisé en ce que**, lorsque l'électrode de mesure (2) est montée, la languette de retenue (7) bloque un mouvement de dégagement de l'électrode de mesure (2) pour qu'elle se dégage de l'engagement de blocage (14) de l'élément de blocage, et de préférence, **en ce que** le mouvement de dégagement de l'électrode de mesure (2) peut être déclenché par déviation élastique de la languette de retenue (7).

7. Système de capteur selon l'une des revendications 5 ou 6, **caractérisé en ce que** l'élément de blocage (14) est disposé sur la languette de retenue (7) de l'élément de fixation (5), ou **en ce que** l'élément de blocage (14) est disposé de manière fixe par rapport à la languette de retenue (7), ou **en ce que** l'élément de blocage (14) est disposé sur l'électrode de mesure (2).

8. Système de capteur selon l'une des revendications 5 à 7, **caractérisé en ce que** l'électrode de mesure (2) peut être bloquée au moyen de l'élément de blocage (14) exclusivement dans une direction transversale à l'extension longitudinale locale (10) de l'électrode de mesure (2), de préférence, **en ce que** l'élément de blocage (14) est disposé à l'extrémité libre de la languette de retenue (7), et plus préférablement, **en ce que** l'élément de blocage (14) est conçu en tant que partie d'un guide longitudinal pour l'électrode de mesure (2) dans la direction de l'extension longitudinale locale (10) de l'électrode de mesure (2).

9. Système de capteur selon l'une des revendications 5 à 8, **caractérisé en ce que** l'élément de blocage (14) fournit un chanfrein de montage (13) de la languette de retenue (7), et/ou **en ce que** l'élément de blocage (14) présente une partie en forme de crochet (16) de telle sorte qu'un mouvement de l'électrode de mesure (2) montée en direction opposée au mouvement de montage (8) produit une force sur la languette de retenue (7) dans la direction de la position de repos.

10. Système de capteur selon l'une des revendications précédentes, **caractérisé en ce que**, lorsque l'électrode de mesure (2) est montée, la languette de retenue (7) de l'élément de fixation (5) est déviée au moins légèrement de manière élastique et **en ce que** la force de rappel élastique agit sur l'électrode de mesure (2), en particulier sensiblement transversalement à une face plate (2a) de l'électrode de mesure (2), de préférence, **en ce que**, lorsque l'électrode de mesure (2) est montée, la languette de retenue (7) exerce une pression sur l'électrode de mesure (2) par sa force de rappel s'exerçant sur un élément de paroi (17), de préférence sur un élément de paroi (17) de l'élément de fixation (5) ou du composant de support (6).

11. Système de capteur selon l'une des revendications précédentes, **caractérisé en ce que** l'élément de fixation (5) comporte un cadre de retenue (18) dans lequel est disposée la languette de retenue (7), de préférence, **en ce que** le cadre de retenue (18) est formé d'un seul tenant avec la languette de retenue (7), et plus préférablement, **en ce que** le cadre de retenue (8) est réalisé conjointement avec la languette de retenue (7) par un procédé de moulage par injection de matière plastique.

12. Module capteur comportant un composant de support (6) et un système de capteur capacitif (1) selon l'une des revendications précédentes, dans lequel l'électrode de mesure (2) du système de capteur (1) est fixée sur le composant de support (6) par l'intermédiaire dudit au moins un élément de fixation (5) .

13. Module capteur selon la revendication 12, **caractérisé en ce que** l'élément de fixation (5) est relié d'un seul tenant au composant de support (6), de préférence, **en ce que** l'élément de fixation (5) est relié d'un seul tenant à un élément de paroi (17) de l'élément de support (6), et de préférence, **en ce que** l'élément de fixation (5) s'étend sensiblement parallèlement au plan de paroi de l'élément de paroi (17) .

14. Procédé de montage de l'électrode de mesure d'un système de capteur capacitif (1) selon l'une quelconque des revendications 1 à 13, dans lequel il est prévu au moins deux éléments de fixation (5) et dans lequel l'électrode de mesure (2), pour sa fixation, est poussée sous les languettes de retenue (7) des éléments de fixation (5) par une face plate (2a) dans un mouvement de montage unique (8), en particulier linéaire, qui dévie élastiquement les languettes de retenue (7).

15. Procédé selon la revendication 14, **caractérisé en ce que** l'électrode de mesure (2), pour sa fixation, est poussée sensiblement simultanément sous les languettes de retenue (7) d'au moins deux éléments de fixation (5), cela déviant élastiquement les languettes de retenue (7).
